# EUROPEAN PATENT APPLICATION

(11) **EP 4 290 574 A1**
(43) Date of publication of application: **13.12.2023**
(21) Application number: 22305842.1
(22) Date of filing: 09.06.2022
(51) Int. Cl.: H01L 23/538

(54) **POWER MODULE WITH INTEGRATED POWER BOARDS AND PCB BUSBAR**

(71) Applicant: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: PERRIN, Rémi, 35708 RENNES CEDEX 7 (FR); LEFEVRE, Guillaume, 35708 RENNES CEDEX 7 (FR)
(74) Representative: Plasseraud IP

(57) **Abstract**

Power module, having:
- at least a pair of integrated power boards (1a, 1b) with at least two embedded power semiconductor dies (11a, 11b, 11'a, 11'b), a first integrated power board (1a) of said pair having in line a first positive terminal (110a), a first power semiconductor die (11a), a first middle point terminal (112a, 113a), a second power semiconductor die (12a) and a first negative terminal ( 114a) and having a first current flow direction from said first negative terminal (114a) to said first positive terminal (110a), a second integrated power board (1b) of said pair having in line a second positive terminal (111b), another first power semiconductor die (11b), a second middle point terminal (113b), another second power semiconductor die (12b) and a second negative terminal (114b) and having a second current flow direction from said second negative terminal to said second positive terminal and,
- a PCB busbar (2), to provide a positive voltage BUS+, and a negative voltage BUS-current supply to said first and second integrated power boards, having opposite first face (2a) and second face (2b) and having power conductive tracks (211a, 211b, 212a, 212b) and connection pads (21a, 21b, 22a, 22b), on both said first face and said second face, wherein said first integrated power board (1a) is positioned on said first face (2a) of the PCB busbar and has its first positive terminal (110a), first middle point terminal (112a, 113a) and first negative terminal (114a) connected to connection pads on said first face of said PCB busbar, wherein said second integrated power board (1b) is positioned on said second face (2b) of the PCB busbar has its first positive terminal (110b, 111b), first middle point terminal (112b, 113b) and first negative terminal (114b) connected to further connection pads (21b, 22b, 23b) on said second face of said PCB busbar and wherein said first integrated power board (1a) and said second integrated power board (1b) are oriented head to tail to have the first current flow direction and the second current flow direction in opposite directions.

## Description

### Field of the invention

### Background

In power electronics, power semiconductors turn on and off a current flow to control an electric power. In a transistor-based (bipolar or MOSFET) voltage source converter, this switching means commutation of current back and forth between transistors, freewheeling diodes, and a power supply. In an ideal circuit, the drivers of the transistors controls the shape of voltage and current waveforms. No voltage spikes or oscillations exist. The reverse recovery current in the diodes and transistors tail currents are the only deviations from the ideal waveforms. Such a switching transition can be considered as "clean switching". However, real power circuits contain inductances and capacitances as major parasitic elements, which cause serious deviations from clean switching. Basic effects of parasitic inductances are:
- a voltage dip during turn-on of a controlled transistor, caused by rise of current;
- a voltage spike at a diode when the reverse recovery current is falling;
- a voltage spike during turn-off of the transistor, caused by current decay.

In addition, parasitic capacitances in conjunction with parasitic inductances form resonant circuits, leading to undesired oscillations after each switching transition.

Beside these basic effects, parasitic inductances alters the switching characteristics of bipolar power semi-conductors. Therefore, optimum circuit design with minimum parasitic inductance is a prerequisite for the optimization of power semiconductors towards lowest losses as discussed in Miller, Gerhard "New Semiconductor Technologies challenge Package and System Setups", CIPS, Nurnberg, 2010.

In document K. Takao and S. Kyogoku, "Ultra low inductance power module for fast switching SiC power devices," presented at the International Symposium on Power Semiconductor Devices and IC's (ISPSD), 2015, pp. 313-316, a good example of how to low down the stray inductance with an antiparallel arrangement of each phase-leg of a converter. The stray inductance in between a parallel and an antiparallel arrangement is dropping from 19.8 nH down to 3.8 nH. This reduction comes from the electromagnetic field cancellation of two adjacent conductors carrying current in opposite directions within a same substrate.

As seen above, parasitic inductance is a well-known issue that any power module designer is trying to low down as much as possible. One of the ways to stabilize the transistor and its power cell including parasitic inductance, is to add decoupling capacitor at the closest of the switching devices. The goal of this decoupling capacitor is to provide a clean energy source to the power die with the minimum distance to avoid RLC parasitic polluting the source at the vicinity of the power transistors. Those decoupling capacitors are often ceramic based, for their behavior in high frequency, coupled with film capacitors for filtering due to their energy density.

For power module using integrated power board (IPB) technology, another challenge to address is the compatibility between each material used in the PCB stack of such IPB as discussed in S. Lu, T. Zhao, R. P. Burgos, G. Lu, S. Bala and J. Xu, "PCB-Interposer-on-DBC Packaging of 650 V, 120 A GaN HEMTs," 2020 IEEE Applied Power Electronics Conference and Exposition (APEC), 2020, pp. 370-373, doi: 10.1109/APEC39645.2020.9124159. Copper, epoxy, silicon and so on, have different thermal expansion coefficient (CTE) which limits the package reliability when facing high thermal stress.

Also known is that in the packaging design the matching of the different CTE of each material chosen is a key to enhance the reliability of the product. In the case of PCB based packaging the CTE mismatch can be quite high already in between copper and epoxy. Adding ceramic capacitors and soldering on top is identified as a weakness point during cycling as discussed in K. McKinney, R. Rice, and C. Wu, "Mechanical Failure Characteristics of Ceramic Multilayer Capacitors," J. Amer. Ceram. Soc., vol. 69, no. 10, pp. C228, 1986. Often potting is used to release the constrain on the package and avoid capacitor ceramic cracking.

In the case of an IPB design, adding ceramic based capacitor makes the thermal expansion coefficient difference increase in the stack. Thus, the reliability of the package decreases.

Moreover, IPB packaging is targeting high density applications and the designers prefer to avoid adding elements in the packages to limit their footprint. However there remains a need for a higher energy density capacitor such as a ceramic based or film capacitor.

In this context, a solution which avoids the use of decoupling capacitors near the dies in IPB packages by reducing the stray inductance in the packages is to be found.

An intermediate solution where silicon capacitors are embedded in the IPB may be considered. However, silicon capacitor having a low capacitive density, such capacitors could provide a local decoupling for fast switching but there remains a need for a higher energy density decoupling capacitor.

### Summary of the invention

The present disclosure concerns power modules based on a capacitor less integrated power board (IPB) design that is allowed by the development of a specific PCB busbar between at least one pair of IPBs, in particular IPBs each forming a half bridge electrically connected in parallel and an anti-parallel assembly of integrated power modules on such PCB busbar.

More precisely, the present disclosure concerns a power module, having:
- at least a pair of integrated power boards with at least two embedded power semiconductor dies, a first integrated power board of said pair having in line a first positive terminal, a first power semiconductor die, a first middle point terminal, a second power semiconductor die and a first negative terminal, and having a first current flow direction from said first negative terminal to said first positive terminal, a second integrated power board of said pair having in line a second positive terminal, another first power semiconductor die, a second middle point terminal, another second power semiconductor die and a second negative terminal, and having a second current flow direction from said second negative terminal to said second positive terminal and,
- a PCB busbar, to provide a positive voltage BUS+, and a negative voltage BUS-current supply to said first and second integrated power boards, having opposite first face and second face and having power conductive tracks and connection pads on both said first face and said second face, wherein said first integrated power board is positioned on said first face of the PCB busbar and has its first positive terminal, first middle point terminal and first negative terminal connected to connection pads on said first face of said PCB busbar, in which said second integrated power board is positioned on said second face of the PCB busbar has its first positive terminal, first middle point terminal and first negative terminal connected to further connection pads on said second face of said PCB busbar and in which said first integrated power board and said second integrated power board are oriented head to tail to have the first current flow direction and the second current flow direction in opposite directions.

In the present design the IPBs of a pair of IPBs are connected by the PCB busbar. The IPB are facing each other with 180° rotation. In each IPB, the current is flowing from the BUS- to BUS+ connection point generating an electromagnetic field. The opposite fields generated are cancelling each other. The parasitic inductance is therefore reduced, moreover the interconnection with the busbar is keeping the parasitic inductance low.

The IPBs on each face of the busbar comprise two power semiconductors arranged to form half bridges and the use of the PCB busbar permits to have fast switching characteristics due to the minimization of parasitic inductances and capacitances allowed with such design.

In realization modes which may be combined or alternates:
The PCB busbar may comprise at least one positive voltage distribution conductive track and at least one negative voltage distribution conductive track isolated from each other with an isolation substrate and may comprise on a first side of the PCB busbar:
- on the first face of the PCB busbar a first connection area, to connect said positive voltage distribution conductive track to the positive voltage BUS+, said first connection area being connected to a first connecting pad on the first face of the PCB busbar to connect the first positive terminal of the first integrated power board, and to a second connecting pad on the second face of the PCB busbar to connect the second positive terminal, through said positive voltage distribution conductive track and through first vias in the PCB busbar;
- on the second face of the PCB busbar a second connection area, to connect said negative voltage distribution conductive track to a negative voltage BUS+, said second connection area being connected to a third connecting pad on the second face of the PCB busbar to connect the second negative terminal and to a fourth connecting pad on the first face to connect the first negative terminal, through said negative voltage distribution conductive track and through second vias in the PCB.

The PCB busbar may comprise further at least one third connection area to provide an output electric connection on a second side of the PCB busbar and comprises:
- at least one output connecting track, output connecting vias and output connecting pads to connect said first middle point terminal on the first face of the PCB and said second middle point terminal on the second face of the PCB;

The first side may be a first longitudinal side of said PCB busbar and the second side may be a first lateral side of said PCB busbar.

The power semiconductor dies may comprise gate terminals or base terminals connected to gate or base control terminals on the PCB busbar through gate or base connection pads, gate or base connection tracks.

The power module may comprise further integrated power boards located by pairs on said opposite first face and second face of the PCB, sidewise to the first pair of integrated power boards and connected to the PCB busbar tracks.

The integrated power boards may be oriented so that the current directions of each integrated power board is the opposite of the current direction of its closest neighbors.

Parasitic RLC elements may be at least partially adjusted within the PCB busbar with an adaptation of the thickness of insulating and conductive layers of the PCB busbar

In a preferred embodiment, the PCB busbar may comprise a main decoupling capacitor connected to said positive voltage distribution conductive tracks and negative voltage distribution conductive tracks. This permits to reduce the size of the IPBs and limit their thermal stress as the main decoupling capacitor, ceramic or film is outside the IPBs. Such filtering capacitor may be located on contact pads on a third side of the PCB busbar.

An advantage of the present design is that the sub-nH parasitic stray inductance resulting from this assembly allows to reject the decoupling cap outside of the complexity of the IPB module assembly. By lowering down the parasitic inductance as low as sub-nH, it is not necessary to keep a clean energy source near the die to get clean switching behaviour of the die. Thus, the decoupling capacitor acting as the energy source does not need to be place near the die or the dies.

The assembly may also comprise at least one additional silicon decoupling capacitor in the busbar substrate, such a silicon capacitor, while offering little capacitance, remains in a temperature expansion coefficient compatible with the PCB busbar.

The power module may comprise heatsinks on said integrated power boards on both sides of the PCB busbar. This configuration permits a compact but efficiently cooled design.

Each board of a pair of integrated power boards may form a half bridge.

In another design, all pairs of integrated power boards are connected in parallel to form a single half bridge.

### Brief description of the drawings

A detailed description of exemplary embodiments of the invention will be discussed hereunder in reference to the attached drawings where:
Figure 1: A perspective view of a power module in accordance with the present disclosure;
Figures 2A, 2B, 2C: side cut views at different locations of an example of realization of a power module in accordance with the present disclosure;
Figure 3: a schematic view of an example of a part of a PCB layout adapted for a power module according to the present disclosure.
Figure 4: An example of power module according to a further realization mode of the present disclosure.

### Detailed description of embodiments of the invention

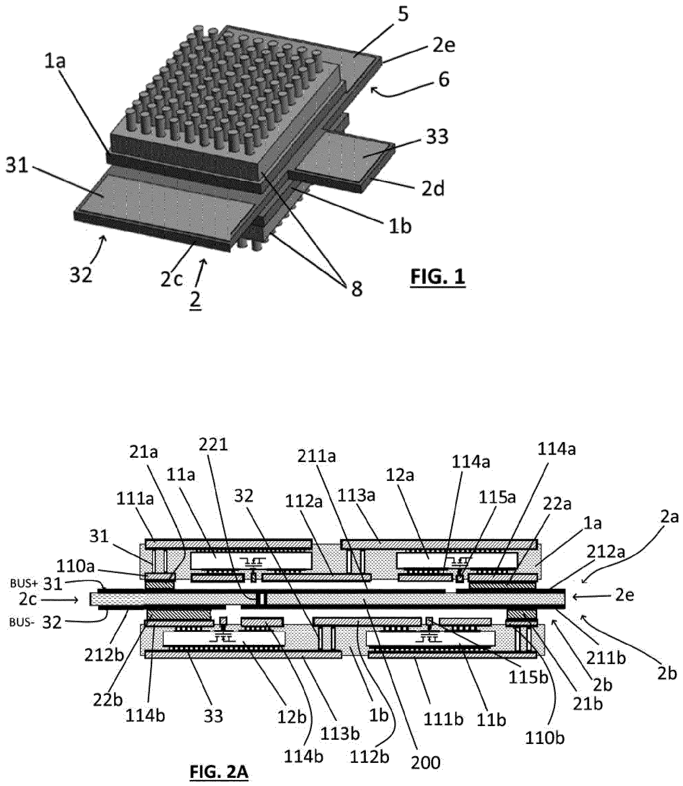

The present invention concerns a power module as disclosed in figure 1 having at least a pair of integrated power boards (IPB) 1a, 1b located on a PCB busbar 2, such PCB busbar providing at least a BUS+ contact pad 31 and a BUS- contact pad 32 to supply current to the pair of IPBs.

As shown in figure 2A a first lateral cut view at a first position of the power module, the pair of integrated power boards 1a, 1b comprise each two embedded power semiconductor dies 1a, 12a, 11b, 12b. Such semiconductors are represented as MOSFET transistors but may also be any kind of power switches (IGBT, FET....) or any other solid-state power switching semiconductors. The first IPB 1a on top of the PCB busbar in the figure comprises two power semiconductor dies 11a, 12a and the second IPB under the PCB busbar comprises two power semiconductor dies 11b, 12b. The second IPB 1b is turned at 180° from the first IPB 1a.

Each IPB has in line a first positive terminal 110a, 110b, a first power semiconductor die 11a, 11b, a first middle point terminal 112a, 113a, 112b, 113b, a second power semiconductor die 12a, 12b and a first negative terminal 114a, 114b. The current flow direction in the IPB in use goes from said first negative terminal 114a to said first positive terminal 110a.

The PCB busbar is organized to provide a positive voltage BUS+, and a negative voltage BUS- current supply to the first and second IPBs.

According to the disclosed design, the PCB busbar has BUS+ connection area 31 on a first face 2a and a BUS- connection area 32 on a second face 2b of a first longitudinal end also designated as a first side 2c of the PCB busbar. As the IPBs are located head to tail on both faces of the PCB busbar the connection of the positive terminals 110a, 110b of such IPBs must be done on both faces of the PCB. Then, from the BUS+ connection area 31, a first track 211a comprises a connection pad 21a to connect the first positive terminal 110a and is connected to vias 221 to cross the PCB thickness, such vias being connected to a second track 211b which comprise a further pad 21b at the other side of the PCB to connect the second positive terminal 110b.

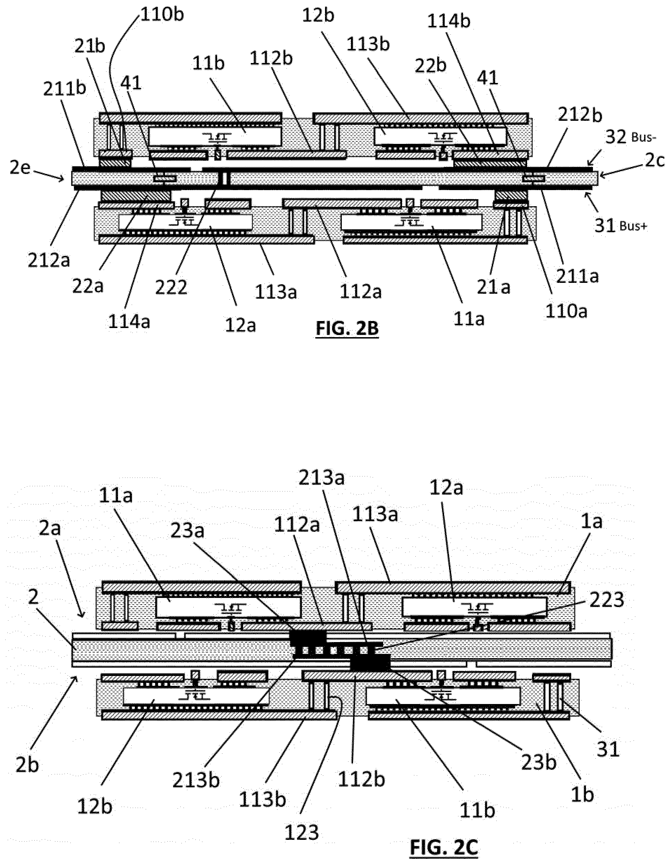

Figure 2B is a lateral cut view at another position of the power module turned upside down. In figure 2B is shown the path for connecting the negative terminals 22a, 22b of the two IPBs to the BUS- connection area 32. A third track 212b starts at connecting area 32 at the first longitudinal end 2c of the PCB, comprises a third connecting pad 22b for the second negative terminal 114b and is connected to a fourth track 212a on the other face of the PCB through vias 222. The fourth track 212a is connected to a fourth connecting pad 22a and ends at a second longitudinal end also called third side 2e of the PCB.

This case can be described as follows, two IPBs with a 2 in 1 configuration are connected by a PCB busbar. The IPB are facing each other with 180° rotation. In each IPB, the current is flowing from the BUS- to BUS+ connection point generating an electromagnetic field. The opposite fields generated are cancelling each other. The parasitic inductance is therefore reduced, moreover the interconnection with the busbar is keeping the parasitic inductance low.

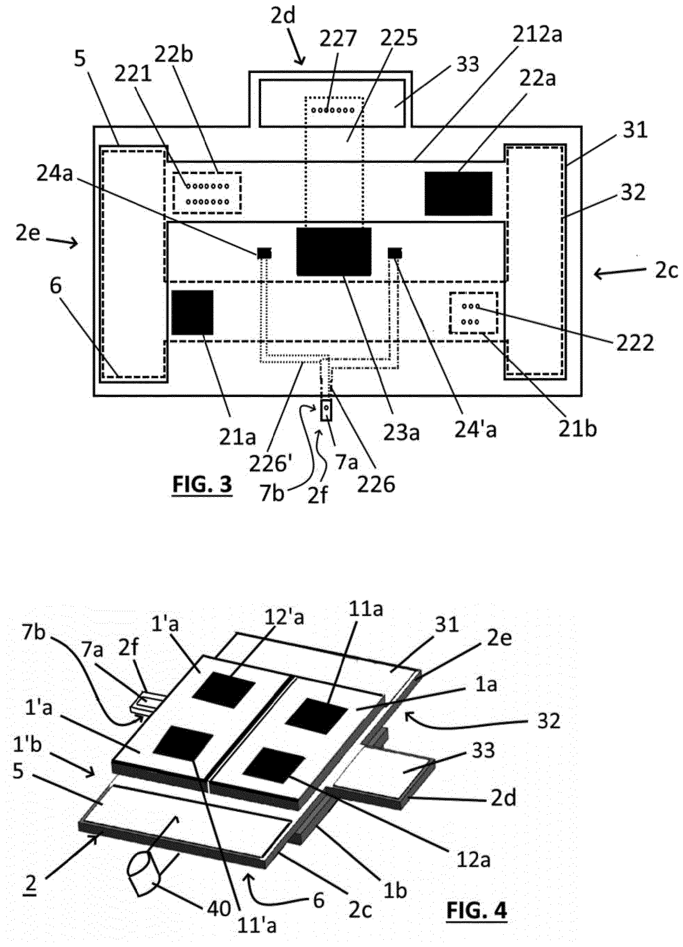

Figure 2C shows a possible connection of the first middle point terminal 112a of the first IPB 1a and the second middle point connection 112b of the second IPB 1b through embedded tracks 213a, 213b and embedded vias 223. An output track 225 shown in the example of PCB layout of figure 3 is connected to an output pad 33 on a second side 2d, or first lateral end, of the PCB.

The connections of the gates not shown are done according to the wiring of the modules. All gates may be separated and connected to their own contact pad on a side 2f of the module or the gates of upper branch power semiconductors may be connected together to a contact pad 7a in figure 4 while the lower branch semiconductors have their gates connected together to a contact pad 7b.

Figure 3 provides an example of PCB layout where the BUS+ and BUS- tracks are laterally offset on the PCB to avoid vias 221 of figure 2A and vias 222 of figure 2B. The BUS+ circuit comprises BUS+ connection pad 32, track 212a, first positive connection pad 22a and capacitor connection pad 5 on a first face of the PCB. The middle point connections output on the drawing showing the second face of the PCB comprises connection pad 23a, embedded track 225, vias 227 and surface connection pad 33. The same configuration is provided on the first face of the PCB (dotted lines on the drawing). Such simplified layout may be improved to provide larger connection pads for the power terminals of the IPBs. Gate connection circuits may comprise connection pads 24a, 24'a on an upper face and gate connection pads 24b, 24'b not shown on a lower face, embedded tracks 226, 226' arranged to provide the necessary gate control connections with connection pads 7a, 7b. A possible wiring is to have the gates of semiconductors 11a, 11b wired together to a first gate connection pad e.g. 7a and the gates of semiconductors 12a, 12b wired together to a second gate connection pad e.g. 7b or to have each gate wired to its own connection pad.

Back to figure 2B, the capacitor connections 5, 6 on a third side 2e of the PCB receive a main decoupling capacitor 40 connected to said positive voltage distribution conductive tracks and negative voltage distribution conductive tracks. This capacitor which is outside the integrated power boards provides a global energy source sufficiently close to the power transistors without reducing the lifetime of the IPBs.

The design obtained where each side and each face of the PCB has a connection area makes it simple to connect and efficient.

Additional silicon decoupling capacitors 41 may be embedded in the busbar substrate which is less subject to temperature cycling than the IPBs.

By lowering the stray inductance of the package and the IPBs interconnection, it is possible to avoid the constraints related to the integration of close decoupling ceramic capacitors. The sub-nH PCB busbar and anti-parallel technique avoid large decoupling ceramic capacitors near the dies. In other words, the capacitive devices are located apart from the switching cells with a busbar interconnection in between.

The capacitive elements being located out of the IPBs makes manufacturing much easier, improve the reliability of the package and reduce the cost due to simplified manufacturing process

In the packaging design the matching of the different TEC is not limited by ceramic capacitors thus providing an enhanced reliability for the product.

Figure 4 shows a power module provided with two pairs of IPBs each having two power semiconductor dies 11a, 12a, 11'a, 12'a in order to make a four IPBs module.

The module may comprise more than two pairs of IPBs in order to increase the current capacity of the power module.

A power module where the gates and middle point terminals of the IPBs are separated can also be constructed using the IPBs on both sides of a PCB busbar configuration of the present disclosure.

In each IPB, the current flowing from the BUS- to BUS+ connection point is generating an electromagnetic field. In addition, since the IPBs of each pair are facing each other with a 180° rotation, the opposite fields generated are cancelling each other. The parasitic inductance is therefore reduced.

When more than a pair of head to tail oriented IPBs are used, the integrated power boards may be oriented so that the current directions of each integrated power board is the opposite of the current direction of its closest neighbor or neighbors.

Moreover, the interconnection with the busbar is designed to keep the parasitic inductance low by reducing the height of the connecting pads and limiting the length of the tracks. The global package assembly is poorly inductive which causes the sub-nH parasitic stray inductance resulting from this assembly to allow to reject the decoupling capacitor outside of the complexity of the IPB module assembly. By lowering down the parasitic inductance as low as sub-nH, it is not necessary to keep a clean energy source near the die to get clean switching behavior of the die. Thus, the decoupling capacitor acting as the energy source does not need to be placed near the dies.

The busbar may be a 4 layers PCB with DC+DC- on two opposed layers with one embedded layer to provide crossing tracks and an additional layer used for the middle point and the gates connections when the gates are connected through the PCB busbar. The external middle point connection is preferably made perpendicular from DC+ and DC- for electromagnetic decoupling. The IPB connections are using either double anti-parallel configurations or a single anti-parallel one. This means an alternance of DC+ and DC- connection points on both faces by flipping two facing IPBs.

The IPB modules can either be brazed, silver sintered or mechanically attached to the busbar. Short connections to the PCB busbar are preferred in order to limit inductance.

The object of the present disclosure may be used in applications requiring power switching such as power converters, motor control or inverters.

The hereabove description concerns examples of realization and should not be considered as limitative. Other designs may be possible within the scope of the attached claims, in particular the power module may comprise more than two pairs of IPBs on a single PCB busbar and the connections of the middle point terminals may be separated or common on each face while the connections of the gates may be separated or grouped depending on the configurations of the modules.

## Claims

1. - Power module, having:
- at least a pair of integrated power boards (1a, 1b) with at least two embedded power semiconductor dies (11a, 11b, 11'a, 11'b), a first integrated power board (1a) of said pair having in line a first positive terminal (110a), a first power semiconductor die (11a), a first middle point terminal (112a, 113a), a second power semiconductor die (12a) and a first negative terminal ( 114a) and having a first current flow direction from said first negative terminal (114a) to said first positive terminal (110a), a second integrated power board (1b) of said pair having in line a second positive terminal (111b), another first power semiconductor die (11b), a second middle point terminal (113b), another second power semiconductor die (12b) and a second negative terminal (114b) and having a second current flow direction from said second negative terminal to said second positive terminal and,
- a PCB busbar (2), to provide a positive voltage BUS+, and a negative voltage BUS-current supply to said first and second integrated power boards, having opposite first face (2a) and second face (2b) and having power conductive tracks (211a, 211b, 212a, 212b) and connection pads (21a, 21b, 22a, 22b), on both said first face and said second face, wherein said first integrated power board (1a) is positioned on said first face (2a) of the PCB busbar and has its first positive terminal (110a), first middle point terminal (112a, 113a) and first negative terminal (114a) connected to connection pads on said first face of said PCB busbar, wherein said second integrated power board (1b) is positioned on said second face (2b) of the PCB busbar has its first positive terminal (110b, 111b), first middle point terminal (112b, 113b) and first negative terminal (114b) connected to further connection pads (21b, 22b, 23b) on said second face of said PCB busbar and wherein said first integrated power board (1a) and said second integrated power board (1b) are oriented head to tail to have the first current flow direction and the second current flow direction in opposite directions.

2. - Power module for a power converter according to claim 1 wherein the PCB busbar comprises at least one positive voltage distribution conductive track (211a, 211b) and at least one negative voltage distribution conductive track (212a, 212) isolated from each other with an isolation substrate (200) and comprises on a first side (2c) of the PCB busbar:
- on the first face of the PCB busbar a first connection area (31) to connect said positive voltage distribution conductive track (211a, 211b) to the positive voltage BUS+, said first connection area (31) being connected to a first connecting pad (21a) on the first face (2a) of the PCB busbar to connect the first positive terminal (110a) of the first integrated power board (1a), and to a second connecting pad (21b) on the second face of the PCB busbar to connect the second positive terminal (110b), through said positive voltage distribution conductive track (211a, 211b) and through first vias (221) in the PCB busbar;
- on the second face of the PCB busbar a second connection area (32) to connect said negative voltage distribution conductive track (212a, 212b) to a negative voltage BUS+, said second connection area (32) being connected to a third connecting pad (22b) on the second face (2b) of the PCB busbar to connect the second negative terminal (114b) and to a fourth connecting pad (22a) on the first face (2a) to connect the first negative terminal (114a), through said negative voltage distribution conductive track (212a, 212c) and through second vias (222) in the PCB.

3. - Power module for a power converter according to claim 2 wherein the PCB busbar comprises further at least one third connection area (33) to provide an output electrical connection on a second side (2d) of the PCB busbar and comprises:
- at least one output connecting track (213a, 213b), output connecting vias (223) and output connecting pads (32a, 23b) to connect said first middle point terminal (112a) on the first face of the PCB and said second middle point terminal (112b) on the second face of the PCB;

4. - Power module for a power converter according to claim 3 wherein said first side (2c) is a first longitudinal side of said PCB busbar and said second side (2d) is a first lateral side of said PCB busbar.

5. - Power module for a power converter according to any one of the preceding claims wherein the power semiconductor dies comprise gate terminals or base terminals (115a, 115b) connected to gate or base control terminals (7a, 7b) on the PCB busbar through gate or base connection pads (24a, 24'a), and gate or base connection tracks (226, 226').

6. - Power module for a power converter according to any one of the preceding claims comprising further integrated power boards (1'a, 1'b) located by pairs on said opposite first face and second face of the PCB, sidewise to the first pair (1a, 1b) of integrated power boards and connected to the PCB busbar tracks.

7. - Power module for a power converter according to claim 6 where the integrated power boards (1a, 1'a, 1b, 1'b) are oriented so that the current directions of each integrated power board is the opposite of the current direction of its closest neighbors.

8. - Power module for a power converter according to any one of the preceding claims wherein parasitic RLC elements are adjusted within the PCB busbar with an adaptation of the thickness of insulating and conductive layers of the PCB busbar

9. - Power module for a power converter according to any one of claims 2, 3 or 4, wherein the PCB busbar comprises a main decoupling capacitor (40) connected to said positive voltage distribution conductive tracks and negative voltage distribution conductive tracks and located on contact pads (5, 6) on a third side (2e) of the PCB busbar.

10. - Power module for a power converter according to any one of the preceding claims, comprising at least one additional silicon decoupling capacitor (41) within the busbar substrate.

11. - Power module for a power converter according to any one of the preceding claims, comprising heatsinks (8) on said integrated power boards (1a, 1b, 1'a, 1'b).

12. - Power module for a power converter according to any one of the preceding claims, wherein each pair of integrated power boards (1a, 1b, 1'a, 1'b) form a half bridge.

13. - Power module according to any one of claims 1 to 11, wherein all pairs of integrated power boards (1a, 1b, 1'a, 1'b) are connected in parallel to form a single half bridge.
